# EUROPEAN PATENT SPECIFICATION

(11) **EP 3 568 735 B1**
(45) Date of publication and mention of the grant of the patent: **27.01.2021**
(21) Application number: 17891829.8
(22) Date of filing: 13.12.2017
(51) Int. Cl.: G06F 1/16, G06F 3/044, G06F 3/041, G06F 1/3215, G06F 1/3218, G06F 1/3231, G06F 1/3234, G06F 1/3287, G06F 3/01, H01Q 1/24

(54) **ELECTRONIC DEVICE WITH LIGHT SOURCE**
ELEKTRONISCHE VORRICHTUNGEN MIT LICHTQUELLE
DISPOSITIF ÉLECTRONIQUE AVEC SOURCE DE LUMIÈRE

(30) Priority: 13.01.2017 KR 20170006382
(43) Date of publication of application: 20.11.2019
(73) Proprietor: Samsung Electronics Co., Ltd., Suwon-si, Gyeonggi-do 16677 (KR)
(72) Inventor: AN, Jung-Chul, Suwon-si Gyeonggi-do 16677 (KR); PARK, Jung-Hoon, Suwon-si Gyeonggi-do 16677 (KR); KANG, Kyong-Rok, Suwon-si Gyeonggi-do 16677 (KR); KIM, Dong-Hun, Suwon-si Gyeonggi-do 16677 (KR); BAE, Jong-Kon, Suwon-si Gyeonggi-do 16677 (KR); CHO, Joung-Min, Suwon-si Gyeonggi-do 16677 (KR); KIM, Kwang-Tai, Suwon-si Gyeonggi-do 16677 (KR); BYEON, Hyung-Sup, Suwon-si Gyeonggi-do 16677 (KR)
(74) Representative: Nederlandsch Octrooibureau
(86) International application number: PCT/KR2017/014630
(87) International publication number: WO 2018/131799

(56) References cited:
- WO-A1-2013/035909
- US-A1- 2008 122 803
- US-A1- 2011 227 873
- US-A1- 2012 206 446
- US-A1- 2013 215 086
- US-A1- 2014 112 511
- US-A1- 2016 155 789
- US-B2- 8 339 373
- US-B2- 9 213 445

## Description

### [Technical Field]

Various embodiments of the present disclosure relate to electronic devices, for example, electronic devices including a light source, a display and various sensors.

### [Background Art]

Recently, electronic devices are providing more diversified services and additional functions. To meet users' various needs and raise availability of electronic devices, mobile carriers or manufacturers are competitively coming up with distinct, multi-functional electronic devices.

As a result, electronic devices are coming in various forms and with more functions. For example, earlier-generation mobile communication terminals adopted a keypad as an input device. A recent trend, however, is to combine an input device with a display to implement a touchscreen. A touchscreen-capable input device may sense the user's touch, drag, and generate various input signals depending on the time and location of a touch.

The above information is presented as background information only to assist with an understanding of the present disclosure. No determination has been made, and no assertion is made, as to whether any of the above might be applicable as prior art with regard to the present disclosure.

US 2008/122803 discloses a touch panel which uses at least one infrared source and an array of infrared sensors to detect objects which are in contact with, or close to, the touchable surface of the panel. The panel may be operated in both reflective and shadow modes, in arbitrary per-pixel combinations which change over time. Furthermore, the touch panel may include a display.

US 2011/227873 discloses a touch controlled display device. The device comprises: a display panel including a display panel including a first surface, a second surface opposing the first surface and a plurality of pixels between the first and second surfaces, each pixel including a transmission area and a display area, the transmission area being configured to transmit light therethrough, an infrared source located on the side of the second surface of the display panel and configured to irradiate infrared light toward the first surface through the second surface, and an infrared sensor located on the side of the second surface of the display panel and configured to detect infrared light from the first surface through at least one transmission area of the plurality of pixels.

### [Disclosure of Invention]

### [Technical Problem]

An electronic device may include various sensors to detect its ambient environment and to switch to an operation mode fitting the environment. For example, an electronic device may have an illuminance sensor to control the brightness of the display responsive to the ambient brightness. Some electronic devices may have a gyro sensor and acceleration sensor to detect the orientation in which they are mounted and accordingly switch the screen mode of the display between landscape and portrait. Other electronic devices may have a biometric sensor (or 'biological sensor' or simply 'bio sensor') for use in, e.g., security or health-care applications.

On top of functionality, appearance is another sector that they pursue to distinguish their products from their competitors'. For example, there are ongoing efforts to develop and bring into the market curved displays, full-front displays that employ an entire surface as an output area, wrap-around displays that wrap around the front and rear surface, or foldable displays.

Considerable limitations may be imposed on full-front displays, e.g., in arranging various sensors. For example, sensors intended for detecting the user's view, fingerprint, or iris may be arranged to face the user, e.g., in the direction where a full-front display outputs the screen. Such a sensor, when installed in a full-front display, may be disposed under, e.g., the screen output area of the full-front display. Such a bio sensor may be a combination of a light source and an image sensor. Interference may occur between light emissions from the light source and the display panel, deteriorating image quality.

There may be a curvature limit on curved displays, wrap-around displays, or foldable displays. For example, upon transforming a flat display panel into a curved form, a relative displacement may be caused between the inner surface and outer, damaging the display panel or deforming the array of electrodes. Thus, the transformation of the display panel into a curved form is limited to a predetermined curvature range.

More restrictions may be posed to the display panel curvature because placement of a sensor increases the thickness of the display panel. Since the relative displacement is proportional to the thickness of the display panel, thinning the display panel might render it easier to curve the display panel.

According to an embodiment of the present disclosure, there may be provided an electronic device in which a light source is disposed under a display panel (e.g., a screen output area) to prevent or mitigate quality deterioration.

According to an embodiment of the present disclosure, there may be provided an electronic device in which at least one touch sensor and/or pressure sensor for detecting, e.g., the user's touch, drag, hovering, or pressure may be integrated with a display panel to suppress or mitigate the display panel from thickening, rendering it possible to easily transform the display panel into a curved shape.

According to an embodiment of the present disclosure, there may be provided an electronic device capable of enhancing emission capability when an antenna device (e.g., a radiating conductor) is disposed on the display panel, e.g., the front surface of the display panel.

### [Solution to Problem]

The scope of the invention is defined by the independent claim 1. Further aspects of the invention are outlined in the dependent claims. When the term embodiment is used for describing unclaimed combination of features, the term has to be understood as referring to examples useful for understanding the present invention.

According to an embodiment of the present disclosure, an electronic device may comprise a light source configured to emit light and a display panel configured to output an image, wherein the display panel includes a pixel layer including a plurality of pixels configured to display the image, a driving circuit layer configured to drive at least one of the plurality of pixels, and a light shielding layer disposed adjacent to the driving circuit layer blocking the driving circuit layer from the light, wherein the light shielding layer is grounded to a ground part formed inside the electronic device.

According to an embodiment of the present disclosure, an electronic device may comprise a housing including a first surface and a second surface that faces in a different direction from the first surface, a light source disposed in the housing to emit light towards the first surface, a display panel disposed between the first surface and the light source and including pixels configured to display an image, a driving circuit disposed in the display panel configured to drive the pixels, and a light shielding layer disposed between the driving circuit and the light source, wherein the light shielding layer, as viewed from above the first surface, includes a first area, at least partially, overlapping the light source, a second area surrounding the first area, a blocking pattern formed in the first area to block a part of the light, and a transparent pattern formed in the first area to allow another part of the light.

Other aspects, advantages, and salient features of the disclosure will become apparent to those skilled in the art from the following detailed description, which, taken in conjunction with the annexed drawings, discloses exemplary embodiments of the disclosure.

### [Advantageous Effects of Invention]

As is apparent from the following description, in the electronic device according to an embodiment of the present disclosure, the light shielding layer provided in the display panel may shield at least the driving circuit (and/or driving circuit layer) from light emitted from the light source, preventing or mitigating the screen outputted from the display panel from deteriorating. The light shielding layer may include an electrically conductive material and be grounded to the ground part provided in the circuit board, allowing the display panel to be grounded. According to an embodiment of the present disclosure, the light shielding layer may include an electrically conductive material, and in combination with other electrode layers, form at least one touch sensor (e.g., a touch panel or pressure sensor) for detecting the user's touch, drag, hovering, or pressure. For example, the light shielding layer embedded in the display panel itself may be utilized as part of the touch sensor, configuring a touch screen display while suppressing the display from thickening. As the display is prevented from thickening, the display may easily be curved while being capable of detecting various touch inputs. According to an embodiment of the present disclosure, when an antenna device (e.g., a radiating conductor) is disposed ahead of the display panel, the light shielding layer may function as a reflector. For example, the light shielding layer may radiate wireless signals from the antenna device, enhancing the radiation performance of the antenna device.

### [Brief Description of Drawings]

A more complete appreciation of the present disclosure and many of the attendant aspects thereof will be readily obtained as the same becomes better understood by reference to the following detailed description when considered in connection with the accompanying drawings, wherein:
Fig. 1 is an exploded perspective view illustrating an electronic device according to an embodiment of the present disclosure;
Fig. 2 is a block diagram illustrating an electronic device according to an embodiment of the present disclosure;
Fig. 3 is a view illustrating an example of a configuration of an electronic device according to an embodiment of the present disclosure;
Figs. 4 and 5 are views illustrating a stack structure of components of an electronic device according to an embodiment of the present disclosure;
Fig. 6 is a view illustrating an example of a stack of components of an electronic device according to an embodiment of the present disclosure;
Figs. 7a, 7b and 8 are plan views illustrating an example in which a light shielding layer is formed in an electronic device according to an embodiment of the present disclosure;
Fig. 9 is a view illustrating an example of a stack of components of an electronic device according to an embodiment of the present disclosure;
Fig. 10 is a cross-sectional illustrating an example of a stack of components of an electronic device according to an embodiment of the present disclosure;
Figs. 11 and 12 are views illustrating an example of a stack of components of an electronic device according to an embodiment of the present disclosure; and
Fig. 13 is a plan view illustrating a window member of an electronic device according to an embodiment of the present disclosure.

Throughout the drawings, like reference numerals will be understood to refer to like parts, components, and structures.

### [Mode for the Invention]

Various changes may be made to the present disclosure, and the present disclosure may come with a diversity of embodiments. Some embodiments of the present disclosure are shown and described in connection with the drawings. However, it should be appreciated that the present disclosure is not limited to the embodiments, and all changes or replacements thereto also belong to the scope of the present disclosure.

The terms coming with ordinal numbers such as 'first' and 'second' may be used to denote various components, but the components are not limited by the terms. The terms are used only to distinguish one component from another. For example, a first component may be denoted a second component, and vice versa without departing from the scope of the present disclosure. The term 'and/or' may denote a combination(s) of a plurality of related items as listed or any of the items.

The terms 'front', 'rear surface', 'upper surface', and 'lower surface' are relative ones that may be varied depending on directions in which the figures are viewed, and may be replaced with ordinal numbers such as 'first' and 'second'. The order denoted by the ordinal numbers, first and second, may be varied as necessary.

The terms as used herein are provided merely to describe some embodiments thereof, but not to limit the present disclosure. It is to be understood that the singular forms 'a', 'an' and 'the' include plural references unless the context clearly dictates otherwise. It will be further understood that the terms 'comprise' and/or 'have', when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which the embodiments of the present disclosure belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term 'electronic device' may be any device with a touch panel, and the electronic device may also be referred to as a terminal, a portable terminal, a mobile terminal, a communication terminal, a portable communication terminal, a portable mobile terminal, or a display apparatus.

For example, the electronic device may be a smartphone, a mobile phone, a navigation device, a game device, a TV, a head unit for vehicles, a laptop computer, a tablet computer, a personal media player (PMP), or a personal digital assistant (PDA). The electronic device may be implemented as a pocket-sized portable communication terminal with a radio communication function. According to an embodiment of the present disclosure, the electronic device may be a flexible device or a flexible display.

The electronic device may communicate with an external electronic device, e.g., a server, or may perform tasks by interworking with such an external electronic device. For example, the electronic device may transmit an image captured by a camera and/or location information detected by a sensor to a server through a network. The network may include, but is not limited to, a mobile or cellular communication network, a local area network (LAN), a wireless local area network (WLAN), a wide area network (WAN), the Internet, or a small area network (SAN).

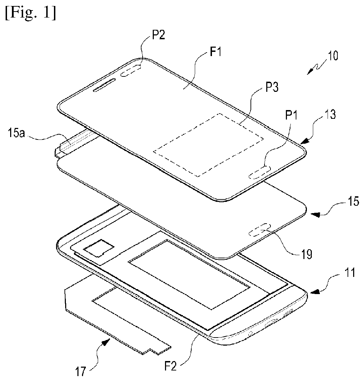

Fig. 1 is an exploded perspective view illustrating an electronic device 10 according to an embodiment of the present disclosure.

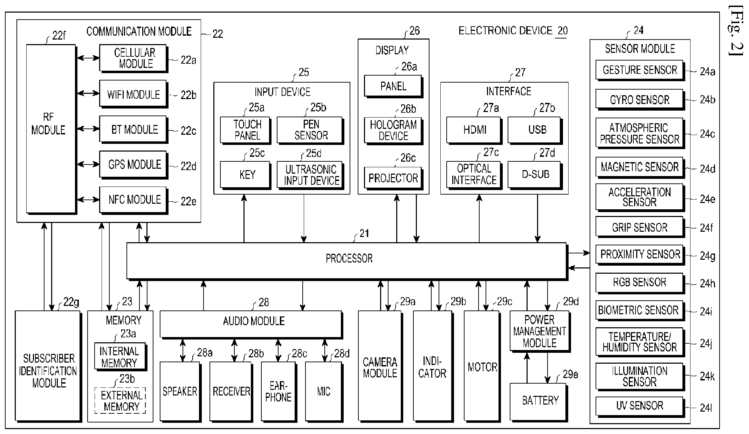

Referring to Fig. 1, the electronic device (e.g., the electronic device 20 of Fig. 2) may include a housing 11 and a display panel 15 mounted in the housing 11. The housing 11 may receive a circuit board 17 and a battery (not shown). A window member 13 is disposed on a first surface F1 of the electronic device 10 to protect the display panel 15, forming the outer appearance of the electronic device 10. For example, the window member 13 may form the first surface F1 of the housing 11. According to an embodiment of the present disclosure, the display panel 15 may be referred to as including the window member 13.

According to an embodiment of the present disclosure, the window member 13 may be disposed on a front surface of the housing 11, and together with the housing 11, form the outer appearance of the electronic device 10. The window member 13 may be formed of a transparent substance, e.g., glass or transparent synthetic resin to protect the display panel 15 from external environment while transmitting images output from the display panel 15. For example, the window member 13 may be mounted in the housing 11, with the display panel 15 attached onto an inner surface of the window member 13. The display panel 15 may be received in a space formed by the housing 11 and the window member 13.

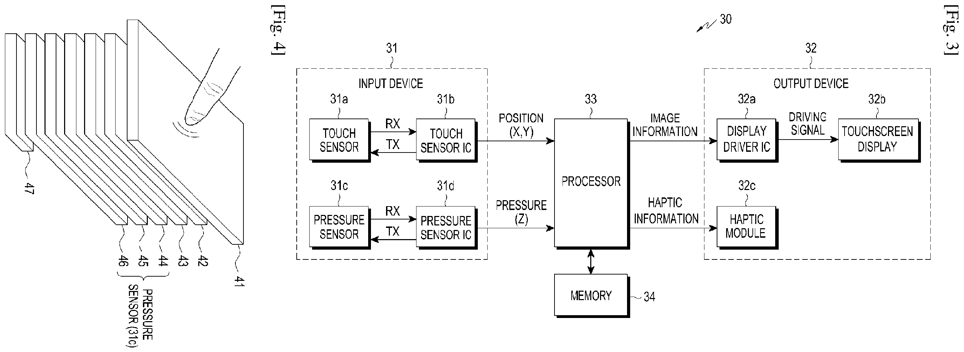

According to an embodiment of the present disclosure, the window member 13 and/or the display panel 15 may be curved and may output the screen through substantially the overall first surface F1 of the electronic device 10. According to an embodiment of the present disclosure, a touch panel and a pressure sensor (e.g., a force sensor) may be integrated with the display panel 15 and/or the window member 13 to detect the user's touch, drag, hovering, touch pressure, or touch time on the window member 13. The arrangement or structure of the touch panel and pressure sensor are described below in further detail with reference to, e.g., Fig. 3.

In certain embodiments, the electronic device 10 detects a proximate or touching external object. The proximate or touching external object can be, for example, but not limited to, a finger, an eye, or a stylus. Where the external object is a finger, certain embodiments described herein can detect the fingerprint on the finger, or the retina of an eye. The electronic device 10 uses a light source that can emit a light, such as an infrared light. The infrared light is reflected off of the finger/eye and received by an image sensor. The light source and the image sensor can be disposed to detect the proximate or touch external object through the display panel. That is, a finger approaching or an eye looking at the image displayed on the display panel can be detected by the image sensor.

The display panel includes a light shielding layer with a pattern of blocking areas and transparent areas, to prevent light emitted from the light source and reflected light from interfering with the image on the display panel. The image displayed on the display panel is displayed by a plurality of pixels that are each driven by a drive circuit. The pattern of blocking areas can block the light from casting upon at least portions of the driving circuits, while the pattern of transparent areas allow the emitted light and reflected light to pass through the display panel.

According to an embodiment of the present disclosure, the circuit board 17 may be received in the housing 11 on a second surface F2 that is positioned opposite the first surface F1. According to an embodiment of the present disclosure, the circuit board 17 may be disposed to face a portion of the display panel 15 with the internal structure of the housing 11 disposed therebetween. The circuit board 17 may include multiple layers, at least one of which may be a conductive layer for grounding (e.g., a ground part). Referring to Fig. 2, various integrated circuit (IC) chips, e.g., a processor, communication module, and audio module described below, may be mounted on the circuit board 17.

According to an embodiment of the present disclosure, the display panel 15 and/or the touch sensor integrated with the display panel 15 may be connected to the circuit board 17 via a flexible printed circuit board 15a. The flexible printed circuit board 15a may extend from the display panel 15. According to an embodiment of the present disclosure, a driving chip(s) for driving the display panel 15 and/or the touch sensor integrated with the display panel 15 may be mounted on the flexible printed circuit board 15a.

According to an embodiment of the present disclosure, the electronic device 10 may include at least one light source 19 and/or a sensor (e.g., an image sensor) corresponding to the light source 19. The light source 19 may be disposed on the display panel 15, e.g., a bottom surface of the display panel 15, or some of the layers constituting the display panel 15 and may emit light transmitted through the display panel 15 and/or the window member 13. According to an embodiment of the present disclosure, while the display panel 15 outputs a screen, the light source 19 may generally remain off. When the user's body part (e.g., her finger) approaches or touches an area corresponding to the light source 19, the light source 19 may be activated to emit light (e.g., an infrared (IR) ray). The approach or touch of the user's body part may be detected by, e.g., a touch sensor integrated with the display panel 15. When the electronic device 10 includes an image sensor corresponding to the light source 19, the image sensor may obtain an image corresponding to the user's body part from the light that has been emitted from the light source 19 and reflected by the user's body part. For example, a combination of the light source 19 and the image sensor may enable the user's fingerprint or iris image to be detected.

Referring to Fig. 1, the light source 19 may be disposed corresponding to a first position PI of a lower part of the first surface F1. When disposed corresponding to the first position PI, the light source 19 may be operated in combination with the image sensor for detecting the user's fingerprint image. According to an embodiment of the present disclosure, the light source 19 may be disposed corresponding to a second position P2 of an upper part of the first surface F1. When disposed corresponding to the second position P2, the light source 19 may be operated in combination with the image sensor for detecting the user's iris image. According to an embodiment of the present disclosure, the light source 19 may be disposed in any position on the first surface F1, e.g., corresponding to a proper position within an area denoted 'P3,' on the first surface F1 depending on its installation purpose or use.

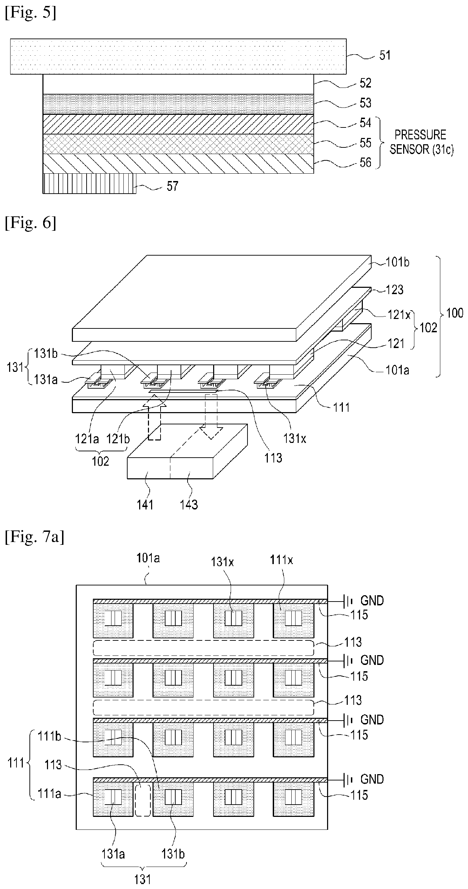

According to an embodiment of the present disclosure, the area where the light source 19 is disposed, such as the first position PI, the second position P2, and/or the area denoted 'P3', may be a portion of the screen output area of the display panel 15. For example, light from the light source 19 may be emitted to the outside through the screen output area (e.g., the display panel 15) and may be refracted or diffused-reflected, causing light leakage. According to an embodiment of the present disclosure, a light shielding layer (e.g., a light shielding layer 111 of Fig. 6) may be used to block a light emission from the light source 19 from reaching, e.g., the driving circuit layer. Such configuration is described below in greater detail with reference to Fig. 6.

Fig. 2 is a block diagram illustrating an electronic device 20 according to an embodiment of the present disclosure.

Referring to Fig. 2, the electronic device 20 may include the whole or part of, e.g., the electronic device 10 of Fig. 1. The electronic device 20 may include one or more application processors (APs) 21, a communication module 22, a subscriber identification module (e.g., a SIM card) 22g, a memory 23, a sensor module 24, an input device 25, a display 26, an interface 27, an audio module 28, a camera module 29a, an indicator 29b, a motor 29c, a power management module 29d, and a battery 29e.

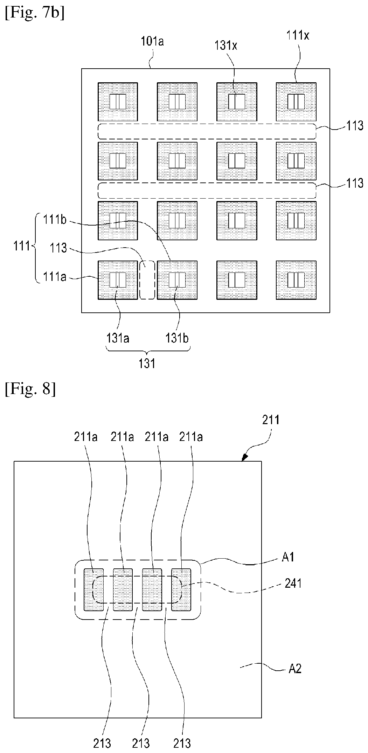

The AP 21 may control multiple hardware and software components connected to the AP 21 by running, e.g., an operating system or application programs, and the AP 21 may process and compute various data. The AP 21 may be implemented in, e.g., a system-on-chip (SoC). According to an embodiment of the present disclosure, the AP 21 may further include a graphic processing unit (GPU) and/or an image signal processor. The AP 21 may include at least some (e.g., the cellular module 22a) of the components shown in Fig. 8. The AP 21 may load a command or data received from at least one of other components (e.g., a non-volatile memory) on a volatile memory, process the command or data, and store various data in the non-volatile memory.

The communication module 22 may include, e.g., a cellular module 22a, a wireless fidelity (Wi-Fi) module 22b, a bluetooth (BT) module 22c, a global navigation satellite system (GPS) module 22d, a near-field communication (NFC) module 22e, and a radio frequency (RF) module 22f.

The cellular module 22a may provide voice call, video call, text, or Internet services through a communication network. According to an embodiment, the cellular module 22a may perform identification or authentication on the electronic device 20 in the communication network using a subscriber identification module 22g (e.g., the SIM card). According to an embodiment of the present disclosure, the cellular module 22a may perform at least some of the functions providable by the AP 21. According to an embodiment of the present disclosure, the cellular module 22a may include a communication processor (CP).

The Wi-Fi module 22b, the BT module 22c, the GPS module 22d, or the NFC module 22e each may include a processor for, e.g., processing data communicated through the module. At least some (e.g., two or more) of the 20 cellular module 22a, the Wi-Fi module 22b, the BT module 22c, the GPS module 22d, or the NFC module 22e may be included in a single integrated circuit (IC) or an IC package.

The RF module 22f may communicate, e.g., communication signals (e.g., RF signals). The RF module 22f may include, e.g., a transceiver, a power amp module (PAM), a frequency filter, a low noise amplifier (LNA), or an antenna. According to an embodiment of the present disclosure, at least one of the cellular module 22a, the Wi-Fi module 22b, the BT module 22c, the GPS module 22d, or the NFC module 22e may communicate RF signals through a separate RF module.

The subscription identification module (e.g., a SIM card) 22g may include, e.g., a card including subscriber information and/or an embedded SIM, and may contain unique identification information (e.g., an integrated circuit card identifier (ICCID) or subscriber information (e.g., an international mobile subscriber identity (IMSI)).

The memory 23 may include, e.g., an internal memory 23a or an external memory 23b. The internal memory 23a may include at least one of, e.g., a volatile memory (e.g., a dynamic RAM (DRAM), a static RAM (SRAM), a synchronous dynamic RAM (SDRAM), etc.) or a non-volatile memory (e.g., a one-time programmable ROM (OTPROM), a programmable ROM (PROM), an erasable and programmable ROM (EPROM), an electrically erasable and programmable ROM (EEPROM), a mask ROM, a flash ROM, a flash memory (e.g., a NAND flash, or a NOR flash), a hard drive, or solid state drive (SSD).

The external memory 23b may include a flash drive, e.g., a compact flash (CF) memory, a secure digital (SD) memory, a micro-SD memory, a min-SD memory, an extreme digital (xD) memory, or a memory stick™. The external memory 23b may be functionally and/or physically connected with the electronic device 20 via various interfaces.

For example, the sensor module 24 may measure a physical quantity or detect an operational state of the electronic device 20, and the sensor module 24 may convert the measured or detected information into an electrical signal. The sensor module 24 may include at least one of, e.g., a gesture sensor 24a, a gyro sensor 24b, an atmospheric pressure sensor 24c, a magnetic sensor 24d, an acceleration sensor 24e, a grip sensor 24f, a proximity sensor 24g, a red-green-blue (RGB) sensor 24h, a bio sensor 24i, a temperature/humidity sensor 24j, an illumination sensor 24k, or an ultra violet (UV) sensor 241. Additionally or alternatively, the sensing module 24 may include, e.g., an e-nose sensor, an electromyography (EMG) sensor, an electroencephalogram (EEG) sensor, an electrocardiogram (ECG) sensor, an infrared (IR) sensor, an iris sensor, or a finger print sensor. The sensor module 24 may further include a control circuit for controlling at least one or more of the sensors included in the sensing module. According to an embodiment of the present disclosure, the electronic device 20 may further include a processor configured to control the sensor module 24 as part of an AP 21 or separately from the AP 21, and the electronic device 20 may control the sensor module 24 while the AP is in a sleep mode.

The input unit 25 may include, e.g., a touch panel 25a, a (digital) pen sensor 25b, a key 25c, or an ultrasonic input device 25d. The touch panel 25a may use at least one of capacitive, resistive, infrared, or ultrasonic methods. The touch panel 25a may further include a control circuit. The touch panel 25a may further include a tactile layer and may provide a user with a tactile reaction.

The (digital) pen sensor 25b may include, e.g., a part of a touch panel or a separate sheet for recognition. The key 25c may include e.g., a physical button, optical key or key pad. The ultrasonic input device 25d may use an input tool that generates an ultrasonic signal and enable the electronic device 20 to identify data by sensing the ultrasonic signal to a microphone (e.g., a microphone 28d).

The display 26 may include a panel 26a, a hologram device 26b, or a projector 26c. The panel 26a may be implemented to be flexible, transparent, or wearable. The panel 26a may also be incorporated with the touch panel 25a in a module. The hologram device 26b may make three dimensional (3D) images (holograms) in the air by using light interference. The projector 26c may display an image by projecting light onto a screen. The screen may be, for example, located inside or outside of the electronic device 20. In accordance with an embodiment, the display 26 may further include a control circuit to control the panel 26a, the hologram device 26b, or the projector 26c.

The interface 27 may include e.g., a high definition multimedia interface (HDMI) 27a, a USB 27b, an optical interface 27c, or a D-subminiature (D-sub) 27d. The interface 27 may include a mobile high-definition link (MHL) interface, a secure digital (SD) card/ multimedia card (MMC) interface, or infrared data association (IrDA) standard interface.

The audio module 28 may converting, e.g., a sound signal into an electrical signal and vice versa. The audio module 28 may process sound information input or output through e.g., a speaker 28a, a receiver 28b, an earphone 28c, or a microphone 28d.

For example, the camera module 29a may be a device for recording still images and videos, and may include, according to an embodiment of the present disclosure, one or more image sensors (e.g., front and back sensors), a lens, an Image signal processor (ISP), or a flash such as an LED or xenon lamp.

The power manager module 29d may manage power of the electronic device 20, for example. According to an embodiment of the present disclosure, the power manager module 29d may include a power management Integrated circuit (PMIC), a charger IC, or a battery or fuel gauge. The PMIC may have a wired and/or wireless recharging scheme. The wireless charging scheme may include e.g., a magnetic resonance scheme, a magnetic induction scheme, or an electromagnetic wave based scheme, and an additional circuit, such as a coil loop, a resonance circuit, a rectifier, or the like may be added for wireless charging. The battery gauge may measure an amount of remaining power of the battery 29e, a voltage, a current, or a temperature while the battery 29e is being charged. The battery 29e may include, e.g., a rechargeable battery or a solar battery.

The indicator 29b may indicate a particular state of the electronic device 20 or a part of the electronic device (e.g., the AP 21), including e.g., a booting state, a message state, or recharging state. The motor 29c may convert an electric signal to a mechanical vibration and may generate a vibrational or haptic effect. Although not shown, a processing unit for supporting mobile TV, such as a GPU may be included in the electronic device 20. The processing unit for supporting mobile TV may process media data conforming to a standard for digital multimedia broadcasting (DMB), digital video broadcasting (DVB), or mediaFlo™.

In certain embodiments, one or more sensors, such as, but not limited to, the biometric sensor 24i, the proximity sensor 24g can be disposed within or directly under the display panel 26a to detect conditions on the opposite side of the display panel 26a.

Each of the aforementioned components of the electronic device may include one or more parts, and a name of the part may vary with a type of the electronic device. The electronic device in accordance with various embodiments of the present disclosure may include at least one of the aforementioned components, omit some of them, or include other additional component(s). Some of the components may be combined into an entity, but the entity may perform the same functions as the components may do.

The term 'module' may refer to a unit including one of hardware, software, and firmware, or a combination thereof. The term 'module' may be interchangeably used with a unit, logic, logical block, component, or circuit. The module may be a minimum unit or part of an integrated component. The module may be a minimum unit or part of performing one or more functions. The module may be implemented mechanically or electronically. For example, the module may include at least one of Application Specific Integrated Circuit (ASIC) chips, Field Programmable Gate Arrays (FPGAs), or Programmable Logic Arrays (PLAs) that perform some operations, which have already been known or will be developed in the future.

According to an embodiment of the present disclosure, at least a part of the device (e.g., modules or their functions) or method (e.g., operations) may be implemented as instructions stored in a computer-readable storage medium e.g., in the form of a programming module. The instructions, when executed by one or more processor (e.g., the processor 21), may cause the processor to carry out a corresponding function. The computer-readable storage medium may be e.g., the memory 23. At least a part of the programming module may be implemented (e.g., executed) by e.g., the processor 120. At least part of the programming module may include e.g., a module, program, routine, set of instructions, process, or the like for performing one or more functions.

The computer-readable recording medium may include a magnetic medium, such as a hard disk, a floppy disk, and a magnetic tape, an optical recording medium, such as a compact disc-read only memory (CD-ROM) or digital video disc (DVD), a magnetic-optical medium, such as a floptical disc, and a hardware device specially configured to store and execute program instructions (e.g., a programming module), such as a read only memory (ROM), random access memory (RAM), or flash memory. Examples of the program commands may include not only machine language codes but also high-level language codes which are executable by various computing means using an interpreter. The aforementioned hardware devices may be configured to operate as one or more software modules to carry out exemplary embodiments of the present disclosure, and vice versa.

Modules or programming modules in accordance with various embodiments of the present disclosure may include at least one or more of the aforementioned components, omit some of them, or further include other additional components. Operations performed by modules, programming modules or other components in accordance with various embodiments of the present disclosure may be carried out sequentially, simultaneously, repeatedly, or heuristically. Furthermore, some of the operations may be performed in a different order, or omitted, or include other additional operation(s).

The embodiments herein are provided merely for better understanding of the present disclosure, and the present disclosure should not be limited thereto or thereby. It should be appreciated by one of ordinary skill in the art that various changes in form or detail may be made to the embodiments without departing from the scope of the present disclosure defined by the following claims.

Fig. 3 is a view illustrating an example of the configuration of an electronic device 30 according to an embodiment of the present disclosure.

Referring to Fig. 3, according to an embodiment of the present disclosure, the electronic device 30 may include a processor 33 (e.g., the AP 21 of Fig. 2), an input device 31 (e.g., the input device 25 of Fig. 2), a memory 34 (e.g., the memory 23 of Fig. 2), and an output device 32. The electronic device 30 may further include a communication module (not shown).

According to an embodiment of the present disclosure, the output device 32 of the electronic device 30 may include a touchscreen display 32b (e.g., the display panel 15 of Fig. 1), a touchscreen display driver IC 32a, and a haptic module 32c. The input device 31 may include a touch sensor 31a, a touch sensor IC 31b, a pressure sensor 31c, and a pressure sensor IC 31d. According to an embodiment of the present disclosure, the touch sensor IC 31b and the pressure sensor IC 31d may be integrated in a single chip. The same or similar components of Fig. 3 as those described above in connection with Figs. 1 and 2 may be skipped from the description.

According to an embodiment of the present disclosure, the touchscreen display 32b may receive an image driving signal from the touchscreen display driver IC 32a. The touchscreen display 32b may display various content and/or items (e.g., text, images (objects), videos, icons, functional objects, or symbols) based on the image driving signal. According to an embodiment of the present disclosure, the touchscreen display 32b may be integrated with the touch sensor 31a and/or pressure sensor 31c (refer to, e.g., Fig. 4) and may simply be referred to as a 'display panel'. The touchscreen display 32b may be driven in a low-power mode.

According to an embodiment of the present disclosure, the touchscreen display driver IC 32a may supply an image driving signal corresponding to the image information received from the processor 33 to the touchscreen display 32b in a preset frame rate. The touchscreen display driver IC 32a may drive the touchscreen display 32b in the low power mode. Although not shown, according to an embodiment of the present disclosure, the touchscreen display driver IC 32a may include a graphic RAM, an interface module, an image processing unit, a multiplexer, a display timing controller (T-con), a source driver, a gate driver, and/or an oscillator.

According to an embodiment of the present disclosure, the touch sensor 31a may experience a variation in a predetermined physical quantity (e.g., voltage, amount of light, resistance, quantity of electric charge, or capacitance) when touched by the user. According to an embodiment of the present disclosure, the touch sensor 31a may be disposed to overlap the touchscreen display 32b.

According to an embodiment of the present disclosure, the touch sensor IC 31b may detect a variation in physical quantity of the touch sensor 31a and calculate the position (X, Y) of the touch based on the variation in physical quantity (e.g., voltage, resistance, or capacitance). The calculated position (coordinates) may be provided (or reported) to the processor 21. For example, when the cover glass (e.g., 41 of Fig. 4 or 51 of Fig. 5) of the touchscreen display is touched by the user's body part (e.g., finger) or electronic pen, the coupling voltage between the transmit (Tx) and/or receive (Rx) end of the touch sensor 31a may be varied. For example, the variation in coupling voltage may be sensed by the touch sensor IC 31b. The touch sensor IC 31b may deliver the coordinates (X, Y) of the position of the touch to the processor 33. The processor 33 may obtain data regarding the coordinates (X, Y) as an event regarding the user's input. For example, a driving circuit or sensor including a combination of the touch sensor 31a and the touch sensor IC 31b may generate an input signal based on the variation in physical quantity, e.g., capacitance.

According to an embodiment of the present disclosure, the touch sensor IC 31b may also be referred to as a touch IC, touchscreen IC, touch controller, or touchscreen controller IC. According to an embodiment of the present disclosure, when the electronic device does not include the touch sensor IC 31b, the processor 21 may function as the touch sensor IC 31b. According to an embodiment of the present disclosure, the touch sensor IC 31b and the processor 33 may be implemented in a single configuration (e.g., a single chip).

According to an embodiment of the present disclosure, the pressure sensor 31c may detect a pressure (or force) by an external body (e.g., a finger or electronic pen). According to an embodiment of the present disclosure, the pressure sensor 31c may be subjected to a variation in physical quantity (e.g., capacitance) between the transmit Tx end (e.g., a first electrode) and the receive Rx end (e.g., a second electrode) by a touch. The physical quantity may be varied by a variation in interval between the transmit Tx end (e.g., the first electrode) and the receive Rx end (e.g., the second electrode) of the pressure sensor 31c.

According to an embodiment of the present disclosure, the pressure sensor IC 31d may detect the variation in physical quantity (e.g., capacitance according to the interval between the Tx end and the Rx end) in the pressure sensor 31c and calculate the pressure Z applied by the touch based on the variation in physical quantity. The pressure sensor IC 31d may calculate, e.g., the variation (speed) in strength of the pressure for a unit time or the direction of the pressure in the pressure sensor 31c. The pressure sensor IC 31d may provide the pressure Z, the strength, speed, and direction of the pressure, and the position (X, Y) of the touch to the processor 33. For example, a driving circuit or sensor including a combination of the pressure sensor 31c and the pressure sensor IC 31d may generate an input signal based on the variation in physical quantity, e.g., capacitance.

According to an embodiment of the present disclosure, the pressure sensor IC 31d may also be referred to as a force touch controller, force sensor IC, or pressure panel IC. According to an embodiment of the present disclosure, the pressure sensor IC 31d, together with the touch sensor IC 31b, may be implemented in a single configuration (e.g., a single chip).

As mentioned above, the touch sensor 31a and the pressure sensor 31c may be disposed to overlap the touchscreen display 32b. The touch sensor IC 31b, the pressure sensor IC 31d, and/or the display driver IC 32a may be mounted on the flexible printed circuit board 15a of Fig. 1 or, together with the AP 21 of Fig. 2, may be implemented in a single configuration (e.g., a single chip).

According to an embodiment of the present disclosure, the haptic module (e.g., a haptic actuator) 32c may provide a haptic feedback (e.g., vibration) to the user according to a control command from the processor 33. For example, the haptic module 32c, upon receiving a touch input (including, e.g., a touch, hovering, or force touch) from the user, may provide a haptic feedback to the user.

According to an embodiment of the present disclosure, the memory 34 may store commands or data associated with operations of the components of the electronic device 30. For example, the memory 34 may store at least one application program including a user interface configured to display a plurality of items on the touchscreen display. For example, the memory 34 may store commands (or instructions) that, when executed, enable the processor 33 to perform the various operations disclosed herein.

According to an embodiment of the present disclosure, the processor 33 may be electrically connected with, e.g., the components 31a, 31b, 31c, 31d, 32a, 32b, and 32c of the electronic device 30 and may perform control, communication-related computation or data processing on the components 31a, 31b, 31c, 31d, 32a, 32b, and 32c of the electronic device 30.

According to an embodiment of the present disclosure, the processor 33 may launch (or execute) an application program (or simply "application") for displaying a user interface on the touchscreen display 32b. The processor 33 may display an array of multiple items on the user interface displayed on the touchscreen display 32b in response to the launching of the application.

According to an embodiment of the present disclosure, the processor 33 (e.g., the AP 21 of Fig. 2) may receive first data (data including the coordinates (X, Y) of the position of the touch) generated by the touch sensor 31a and second data (data including the pressure Z of the touch) generated by the pressure sensor 31c.

According to an embodiment of the present disclosure, the processor 33 may activate at least part of the pressure sensor 31c while the touchscreen display 32b turns off. The processor 33 may at least partially activate the pressure sensor 31c while the touchscreen display 32b turns off. For example, the processor 33 may activate the whole or part of the pressure sensor 31c when a communication, e.g., the touchscreen display 32b, of the electronic device 30 is in a turned-off, standby mode as well as when the electronic device 30 is in an awaken mode. Meanwhile, the processor 33 may at least partially deactivate the touch sensor 31a while the touchscreen display 32b turns off or while the electronic device 30 is in the standby mode. The processor 33 may at least partially deactivate the touch sensor 31a to reduce power consumption in the standby mode and to prevent a malfunction by a touch.

According to an embodiment of the present disclosure, the processor 33 may activate at least part of the pressure sensor 31c when a designated condition is met while the touchscreen display 32b turns off. For example, the processor 33 may activate the pressure sensor 31c from or until designated time after the touchscreen display 32b turns off. As another example, upon sensing the user's use by the gyro sensor or proximity sensor, the processor 33 may activate the pressure sensor 31c. By way of example, when the temperature is lower than a designated value for a designated time interval, when sensing a touch through the touch panel, when the electronic device 30 approaches another external device, or when a stylus equipped in the electronic device 30 is pulled out of the electronic device 30, the processor 33 may activate the pressure sensor 31c. For example, the processor 33 may activate the pressure sensor 31c while an application (e.g., a music player) for performing operation in the standby mode is running.

According to an embodiment of the present disclosure, the processor 33 may deactivate at least part of the pressure sensor 31c when a designated condition is met while the touchscreen display 32b turns off. For example, upon sensing that the electronic device 30 is put in a pocket or bag or flipped over by the proximity sensor, illuminance sensor, acceleration sensor, and/or gyro sensor, the processor 33 may deactivate the pressure sensor 31c. As another example, when the electronic device 30 is connected to an external device (e.g., a desktop PC), the processor 33 may deactivate the pressure sensor 31c.

According to an embodiment of the present disclosure, the processor 33 may activate a designated area alone of the pressure sensor 31c while the touchscreen display 32b is in the off mode. For example, the processor 33 may activate the designated area (e.g., a lower central area of the pressure sensor 31c) of the pressure sensor 31c to reduce power consumption in the standby mode. When the pressure sensor 31c is implemented as a set of two or more sensors, the processor 33 may activate some of the sensors.

According to an embodiment of the present disclosure, the processor 33 may activate or enable the pressure sensor 31c, detecting a pressure using the pressure sensor 31c while the electronic device 30 in the standby mode. For example, the processor 33 may receive data related to a pressure by an external body on the touchscreen display 32b from the pressure sensor 31c while the touchscreen display 32b is in the off mode.

According to an embodiment of the present disclosure, the processor 33 may determine whether the pressure is equal or larger than a selected level based on the pressure-related data, and upon determining that the pressure is equal or larger than the selected level, the processor 33 may perform its function without full turning on the touchscreen display 32b. For example, upon sensing a pressure larger than the designated level, the processor 33 may perform its function. In this case, the processor 33 may turn on part of the touchscreen display 32b. The processor 33 may determine a function that it is to perform based on at least one of the position or strength of the pressure, number of positions, speed, direction, and duration, as follows. For example, upon sensing a pressure in the position corresponding to the lower center of the touchscreen display 32b, the processor 33 may wake up the electronic device 30. Upon sensing a pressure in the position corresponding to the upper and left portion of the touchscreen display 32b, the processor 33 may control the speaker volume of the electronic device 30. Upon sensing a pressure in a position adjacent to a hardware component, e.g., an ear jack or SUB port, the processor 33 may perform a function related to the hardware component. Upon sensing a pressure with a strength more than a designated value, the processor 33 may control the electronic device 30 to enter an emergency mode. The processor 33 may perform different functions depending on the number of positions where pressures are simultaneously sensed.

Although Fig. 3 illustrates that the pressure sensor 31c provides data about the pressure Z to the processor 33, embodiments of the present disclosure are not limited thereto. For example, when the pressure sensor 31c is implemented as a set of two or more sensors, the processor 33 may detect the position of the pressure based on the position of the sensor that has caused a variation in capacitance among the two or more sensors. For example, when the pressure sensor 31c is implemented as a 3x2 array of sensors (i.e., six sensors), the processor 33 may determine the position of the pressure based on the variation in capacitance of each of the six sensors and the position of each of the six sensors. In other words, the processor 33 may determine the position of the pressure without using the touch sensor 31a. Upon sensing the pressure by the pressure sensor 31c, the processor 33 may activate the touch sensor 31a and sense the position of the pressure using the touch sensor 31a.

According to an embodiment of the present disclosure, the processor 33, upon sensing a first level of pressure by a touch by the pressure sensor 31c, may perform a first function. The processor 33 may determine the first function based on at least one of the position or strength of the first level of pressure, number of positions, speed, direction, or duration and perform the determined first function. The first level of pressure may mean a pressure that falls within a designated strength range.

According to an embodiment of the present disclosure, upon sensing a second level of pressure by a touch by the pressure sensor 31c while performing the first function, the processor 33 may perform a second function related to the first function. The processor 33 may determine the second function based on at least one of the position or strength of the second level of pressure, number of positions, speed, direction, or duration. The second level of pressure may mean a pressure that falls within a designated strength range. The second level of pressure may be larger or smaller in strength than the first level of pressure. The second level of pressure may be equal in strength to the first level of pressure. Upon sensing a pressure while performing the first function, the processor 33 may perform the second function related to the first function being performed, thereby executing various functions by a pressure which is a one-dimensional input. The processor 33 may execute a function associated with another function being performed depending on the strength of a pressure on the electronic device 30 after making a single touch on the electronic device 30, thereby leading to increased input convenience.

According to an embodiment of the present disclosure, the electronic device 30 may use values measured by at least one sensor (e.g., an acceleration sensor or gyro sensor) in distinguishing a long press input from a pressure input. The electronic device 30 may also use a fingerprint, camera, or iris in distinguishing a long press input from a pressure input.

The above-described operations of the processor 33 are merely an example, and embodiments of the present disclosure are not limited thereto. For example, the operations of the processor as set forth in the rest of the disclosure may also be appreciated as the operations of the processor 33. Further, at least some of the operations described as the operations of 'electronic device' may also be appreciated as operations of the processor 33.

Figs. 4 and 5 are views illustrating a stack structure of components of an electronic device according to an embodiment of the present disclosure.

An electronic device (e.g., the electronic device 10, 20, or 30 of Figs. 1 to 3) may include a housing having a first surface (e.g., the first surface F1 of Fig. 1) and a second surface (e.g., the second surface F2 of Fig. 1) that faces in a different direction from the first surface and a touchscreen display disposed between the first surface and the second surface and exposed through the first surface.

The stack structure of Figs. 4 and 5 may be applied to the window member 13 and display panel 15 of Fig. 1. Accordingly, the components of Figs. 4 and 5 may be arranged between the front surface (first surface F1) and rear surface (second surface F2) of the electronic device 10 of Fig. 1.

According to an embodiment of the present disclosure, in the stack structure of the touchscreen display, a cover glass 41 or 51 (e.g., the window member 13 of Fig. 1) may transmit light generated by the touchscreen display 43 (e.g., the display panel 15 of Fig. 1). When the user touches the cover glass 41 or 51 with her body part (e.g., finger), a 'touch' (including a touch using an electronic pen) may be performed. The cover glass 41 or 51 may be formed of, e.g., reinforced glass, reinforced plastic, or flexible polymer, protecting the touchscreen display and touchscreen display-equipped electronic device from external impacts. According to an embodiment of the present disclosure, the cover glass 41 or 51 may also be referred to as a glass window or cover window.

The touch sensor 42 (e.g., the touch sensor 31a of Fig. 3) may be subject to variations in various physical quantities (e.g., voltage, amount of light, resistance, quantity of electric charge, or capacitance) by a touch of an external body (e.g., the user's finger or electronic pen). The touch sensor 42 or 52 may detect at least one position of the touch by the external body on the touchscreen display (e.g., the surface of the cover glass 41 or 51) based on the variation in physical quantity. For example, the touch sensor 42 or 52 may include, e.g., a capacitive touch sensor, a resistive touch sensor, IR touch sensor, resistive film touch sensor, or piezo touch sensor. According to an embodiment of the present disclosure, the touch sensor 42 or 52 may also be referred to as a touch panel or in other various denotations depending on its implementations.

The touchscreen display 43 or 53 may output at least one content or item (e.g., text, images, videos, icons, widgets, or symbols). The touchscreen display 43 or 53 may include, e.g., a liquid crystal display (LCD) touchscreen display panel, a light emitting diode (LED) touchscreen display panel, an organic light emitting diode (OLED) touchscreen display panel, a microelectromechanical systems (MEMS) touchscreen display panel, or an electronic paper touchscreen display panel.

According to an embodiment of the present disclosure, the touchscreen display 43 or 53 and the touch sensor (or touch panel) 42 or 52 may be implemented in a single body. In this case, the touchscreen display 43 or 53 may also be referred to as a touchscreen panel (TSP) or touchscreen display panel.

The pressure sensor 31c (e.g., the pressure sensor 31c of Fig. 3) may detect a pressure (or force) by an external body (e.g., the user's finger or electronic pen) on the touchscreen display (e.g., the surface of the cover glass 41 or 51). According to an embodiment of the present disclosure, the pressure sensor 31c may include a first electrode 44 or 54, a second electrode 46 or 56, and a dielectric layer 45 or 55. For example, the pressure sensor 31c may detect the pressure of a touch based on a variation in interval between the first electrode 44 or 54 and the second electrode 46 or 56 and/or variation in capacitance as per the variation in interval that is made by the pressure of the touch. Although Figs. 4 and 5 illustrate that the pressure sensor 31c is implemented in a single sensor, embodiments of the present disclosure are not limited. The pressure sensor 31c may also be implemented as a set of two or more sensors. For example, the pressure sensor 31c may be implemented as a set of six sensors that are arranged in a 3x2 array.

According to an embodiment of the present disclosure, although the pressure sensor 31c is described to include the first electrode 44 or 54, the second electrode 46 or 56, and the dielectric layer 45 or 55, embodiments of the present disclosure are not limited thereto. For example, one (e.g., the first electrode 44 or 54) of the first electrode 44 or 54 and the second electrode 46 or 56 may be an electrode embedded in the touchscreen display 43 or 53. The second electrode 46 or 56 may be disposed corresponding to the electrode embedded in the touchscreen display 43 or 53 with the dielectric layer 45 or 55 disposed therebetween, thereby implementing the pressure sensor 31c.

Upon receiving a touch (including a hovering and/or 'force touch') by an external body (e.g., the user's finger or electronic pen), the haptic module (e.g., haptic actuator) 47 or 57 may provide a haptic feedback (e.g., vibration) to the user. To that end, the haptic module 47 or 57 may include a piezoelectric member and/or a vibration plate.

Various changes may be made to the above-described stack structure of Figs. 4 and 5. For example, the touch sensor 42 or 52 may directly be formed on the rear surface of the cover glass 41 or 51 (so-called cover glass-integrated touch panel). The touch sensor 42 or 52 may separately be formed and put in between the cover glass 41 or 51 and the touchscreen display 43 or 53 (so-called add-on touch panel). The touch sensor 42 or 52 may directly be formed on the touchscreen display 43 or 53 (so-called on-cell touch panel). The touch sensor 42 or 52 may be included inside the touchscreen display 43 or 53 (so-called in-cell touch panel).

According to an embodiment of the present disclosure, an area-type fingerprint sensor that is transparent or opaque may be added to the above-described stack structure.

Fig. 6 is a view illustrating an example of a stack of components of an electronic device according to an embodiment of the present disclosure.

According to an embodiment of the present disclosure, all or some of the components of the electronic device described above in connection with Figs. 3 to 5 may be included. It should be, however, noted that some of the components may be omitted for ease of description and that the present disclosure is not limited to the embodiments.

Referring to Fig. 6, according to an embodiment of the present disclosure, an electronic device (e.g., the electronic device 10 of Fig. 1) may include a light source 141 and image sensor 143 and a display panel 100. The light source 141 and image sensor 143 can detected various conditions on the opposite side of the display panel without deteriorating or interfering with the image displayed on the display panel 100. The light source 141 emits light that can be reflected by an external object. The reflected light is detected by the image sensor 143. The light source 141 may include a light source that emits light, e.g., IR rays. The display panel 100 may at least partially be stacked on the light source 141 and output visual information to the user. In certain embodiments, the image sensor 143 can comprise a complimentary metal oxide semiconductor (CMOS) cell or a charged coupled display (CCD) that converts light or infrared energy into an electronic signal, which can form a portion of a grid of active pixel sensors. The image sensor 143 can be used to detect a variety of conditions, such as the fingerprint of a finger, or a retinal scan. According to an embodiment of the present disclosure, the display panel 100 may at least partially allow light emitted from the light source 141, and at least partially allow light reflected by the external object onto the image sensor 143 without deteroriating or interfering with the images displayed by the display panel.

According to an embodiment of the present disclosure, the display panel 100 may include a sealed pixel layer 102 and a driving circuit layer 131 for driving the pixel layer 102 between a substrate 101a and an encapsulation 101b. The pixel layer 102 may include a plurality of pixels 121 to display an image and may be formed on an inner surface of the encapsulation 101b. According to an embodiment of the present disclosure, a first electrode layer 123 corresponding to the driving circuit layer 131 may be provided on the inner surface of the encapsulation 101b. The pixel layer 102 may be formed on the surface of the first electrode layer 123. The substrate 101a and/or the encapsulation 101b may be formed of a synthetic resin or glass film.

According to an embodiment of the present disclosure, the driving circuit layer 131 may include driving circuits 131a, 131b, and 131x each corresponding to a respective one of the plurality of pixels 121 and facing the pixel layer 102. For example, the driving circuit layer 131 may provide a signal for driving and/or controlling at least one of the plurality of pixels 121. The driving circuit layer 131 and/or the driving circuits 131a, 131b, and 131x constituting the driving circuit layer 131 may be formed of semiconductor, e.g., thin film transistors (TFTs).

According to an embodiment of the present disclosure, light emitted from the light source 141 is prevented from interfering pixel layer 102. The display panel 100 may include a light shielding layer 111. The light shielding layer can include a pattern of blocking areas and transparent areas that prevent the light from deteriorating the image displayed, while allowing emitted light and reflected light to pass through the display panel. The light shielding layer 111 may be formed on a surface of the substrate 101a, facing and/or contacting the driving circuit layer 131. This may be described in greater detail in connection with Figs. 7a to 12. The light shielding layer 111 may be formed on the other surface of the substrate 101a and on the driving circuit layer 131, shutting the driving circuit layer 131 from light emitted from the light source 141. For example, the light shielding layer 111 may prevent light emissions from the light source 141 from distorting or deteriorating the image quality of screen outputted from the display panel 100.

According to an embodiment of the present disclosure, the light shielding layer 111 may be formed of an electrically conductive material and may function as a ground part for the display panel 100. According to an embodiment of the present disclosure, the light shielding layer 111 may be grounded in the electronic device (e.g., electronic device 10 of Fig. 1). For example, the light shielding layer 111 may be grounded to a ground part provided in the circuit board (e.g., the circuit board 17 of Fig. 1) and/or another conductive structure of the electronic device through the flexible printed circuit board (e.g., the flexible printed circuit board 15a of Fig. 1).

According to an embodiment of the present disclosure, the light shielding layer 111 may include a transparent area that transmits light emitted from the light source 141. For purposes of this document, the term "transparent" shall be understood to include material that permits light to pass through, as well as a void, hole, or opening. For example, the transparent area may be rendered to have at least one opening 113 by partially removing the material that forms the light shielding layer 111. According to an embodiment of the present disclosure, the opening 113 may be filled with a light-allowing material. For example, the light shielding layer 111 may include an area formed of a light shielding material that blocks light and an area formed of a light transmitting material. Thus, the display panel 100 may at least partially transmit light emitted from the light source 141.

According to an embodiment of the present disclosure, the light source 141 may remain in an off mode, and upon sensing the user's approach or touch through the touch sensor (e.g., the touch sensor 31a of Fig. 3) and/or pressure sensor (e.g., the pressure sensor 31c of Fig. 3) in the area corresponding to the light source 141, the light source 141 may be activated (e.g., emitting light). Light emitted from the light source 141 may be reflected by the user's body to the inside of the display panel 100. For example, the light reflected by the user's body may be transmitted through the opening 113 and the display panel 100.

According to an embodiment of the present disclosure, the electronic device (e.g., the electronic device 10 of Fig. 1) may further include an image sensor 143 for obtaining an image corresponding to the user's body from the light reflected by the user's body. For example, the user's fingerprint image or iris image may be detected through the image sensor 143. When the image sensor 143 configures an iris recognition sensor, such control may be performed as to activate the light source 141 although the user's body does not directly contact the display panel 100 or the window member 13 of Fig. 1.

According to an embodiment of the present disclosure, the light shielding layer 111 may include multiple blocking areas (and/or blocking patterns) formed of a light shielding material and transparent areas (e.g., the opening 113) formed between the blocking areas. The blocking areas and the transparent areas may be set in various arrays. The transparent area(s) may be formed in an area corresponding to, e.g., the light source 141 and/or the image sensor 143.

Figs. 7a, 7b and 8 are plan views illustrating an example in which a light shielding layer 111 or 211 is formed in an electronic device according to an embodiment of the present disclosure.

As mentioned above, the pixel layer 102 may be a layer formed of an array of a plurality of pixels 121 including a first pixel 121a, a second pixel 121b, and an xth pixel 121x. Some pixels, e.g., the first pixel 121a and the second pixel 121b may be arranged adjacent each other.

Referring to Figs. 7a and 7b, the driving circuit layer 131 may include a first driving circuit 131a for driving the first pixel 121a, a second driving circuit 131b for driving the second pixel 121b, and an xth driving circuit 131x for driving the xth pixel 121x. For example, the driving circuit layer 131 may be a layer formed of an array of the plurality of driving circuits 131a, 131b, and 131x, and each driving circuit 131a, 131b, and 131x may be disposed corresponding to one of the pixels 121a, 121b, and 121x forming the pixel layer 102. For example, when the first pixel 121a and the second pixel 121b are positioned adjacent each other, their respective corresponding first driving circuit 131a and second driving circuit 131b may also be positioned adjacent each other.

According to an embodiment of the present disclosure, the light shielding layer 111 may include a plurality of blocking areas 111a, 111b, and 111x and transparent area(s) (e.g., the opening 113) between the blocking areas 111a, 111b, and 111x which are formed on one surface of the substrate 101a. For example, the light shielding layer 111 may include a first blocking area 111a corresponding to the first driving circuit 131a and a second blocking area 111b corresponding to the second driving circuit 131b. The transparent area may include the opening 113 between the first blocking area 111a and the second blocking area 111b. According to an embodiment of the present disclosure, the opening 113 may be formed in a net shape in one surface of the substrate 101a. For example, the blocking areas 111a, 111b, and 111x may be separated by the opening 113 in one surface of the substrate 101a.

According to an embodiment of the present disclosure, when the light shielding layer 111, e.g., the blocking areas 111a, 111b, and 111x, is formed of an electrically conductive material, and a ground part is provided to, e.g., the display panel (e.g., the display panel 15 of Fig. 1), the light shielding layer 111 may further include a ground pattern 115 for connecting together the blocking areas 111a, 111b, and 111x as shown in Fig. 7a. The ground pattern 115 may be connected to the ground part GND provided in the circuit board (e.g., the circuit board 17 of Fig. 1) through, e.g., a flexible printed circuit board (e.g., the flexible printed circuit board 15a of Fig. 1).

As can be seen, the blocking areas 111a, 111b, ... 111x block can prevent the light emitted from the light source 141 from deteroriating or interfering with the image provided by the pixels by shielding the drive circuits 131a, 131b, ... 131x. At the same time, the transparent areas 113 allow the emitted light to pass through to be reflected by an external object. Additionally, where the transparent areas 113 are non-conductive, there may be no connection path between some of the drive circuits 131, e.g., driver circuit 131a and drive circuit 131x, except along the periphery of the substrate 101a. However, since each of the drive circuits 131 are connected to a ground pattern, all of the drive circuits 131 will operate as though they are electrically connected directly to each other.

According to an embodiment of the present disclosure, the light shielding layer 111 may not include the ground pattern 115 as shown in Fig. 7b. For example, the blocking areas 111a, 111b, and 111x may be areas separated by the opening 113. When the blocking areas 111a, 111b, and 111x are areas separated by the opening 113, the material forming the blocking areas 111a, 111b, and 111x is not necessarily an electrically conductive material.

According to an embodiment of the present disclosure, the first blocking area 111a may shield the first driving circuit 131a from light emitted from the light source 141, and the second blocking area 111b may shield the second driving circuit 131b from light emitted from the light source 141. At least part of the light emitted from the light source 141 may be transmitted through the transparent area (e.g., the opening 113). For example, at least part of the light emitted from the light source 141 may be transmitted through the display panel 100 to the outside of the display panel.

According to an embodiment of the present disclosure, the blocking areas 111a, 111b, and 111x may be formed of a light shielding and electrically conductive material, grounding the driving circuit layer 131 and/or each driving circuit 131a, 131b and 131x. The transparent area may be the opening 113 and/or an array of openings 113 formed by removing the light shielding material from one surface of the substrate 101a. According to an embodiment of the present disclosure, the opening 113 forming the transparent area may be filled with a light transmitting material.

According to an embodiment of the present disclosure, the light shielding layer 111 may be formed in an area corresponding to, at least, the light source 141 (and/or the image sensor 143) in one surface of the substrate 101a. According to an embodiment of the present disclosure, the light shielding layer 111 may be formed, at least, in an area to which light from the light source is radiated in one surface of the substrate 101a. According to an embodiment of the present disclosure, the light shielding layer 111 may be formed over an entire surface of the substrate 101a. According to an embodiment of the present disclosure, the light shielding layer 111 may be formed in an entire surface of the substrate 101a, and the transparent area may be formed as part of the area to which light from the light source 141 is radiated.

The relationship in position between the light shielding layer 111 and the light source 141 is described below in greater detail with reference to Fig. 8.

Referring to Fig. 8, the light shielding layer 211, as viewed from above the first surface (e.g., the first surface F1 of Fig. 1), may include a first area A1 overlapping, at least, the light source 241, a second area A2 surrounding the first area A1, a blocking pattern(s) 211a formed in the first area A1, and a transparent pattern(s) 213. The blocking pattern 211a may block part of light emitted from the light source 241, and the transparent pattern 213 may allow another part of the light emitted from the light source 241. According to an embodiment of the present disclosure, at least one driving circuit (e.g., the driving circuits 111a, 111b, and 111x of Figs. 7a and 7b) may be disposed on the blocking pattern 211a, shielding the same from light emitted from the light source 241. For example, as viewed from above the first surface F1, the blocking pattern 211a may, at least partially, overlap the driving circuit(s) 131a, 131b, and 131x. According to an embodiment of the present disclosure, although no image sensor (e.g., the image sensor 143 of Fig. 6) is shown, when an image sensor is provided that is operated along with the light source 241, the first area A1 may overlap the image sensor as well.

According to an embodiment of the present disclosure, the light shielding layer 211 may be formed of an electrically conductive material on an entire surface of the substrate (e.g., the substrate 101a of Fig. 6). For example, the second area A2 may be formed of an electrically conductive material over substantially the entire area, blocking off light emissions from the light source 241. When formed of an electrically conductive material, the light shielding layer 211 may provide a ground to the display panel (e.g., the display panel 100 of Fig. 6) and/or the driving circuit layer (e.g., the driving circuit layer 131 of Fig. 6). For example, the light shielding layer 211 may be grounded via a connecting means, e.g., a flexible printed circuit board (e.g., the flexible printed circuit board 15a of Fig. 1), to the conductive structure of the electronic device (e.g., the electronic device of Fig. 1) or the circuit board (e.g., the circuit board 17 of Fig. 1).

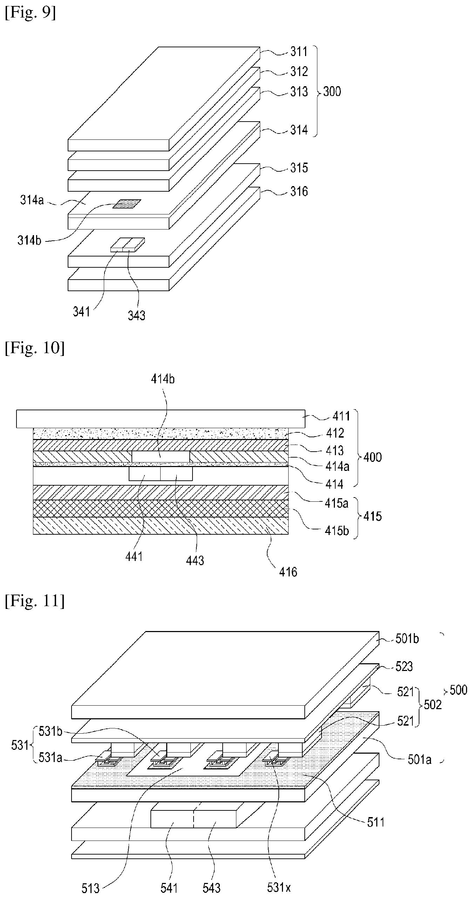

Fig. 9 is a view illustrating an example of a stack of components of an electronic device according to an embodiment of the present disclosure. Fig. 10 is a cross-sectional illustrating an example of a stack of components of an electronic device according to an embodiment of the present disclosure.

Referring to Figs. 9 and 10, according to an embodiment of the present disclosure, an electronic device may include a display panel 300 or 400 and a light source 341 or 441 disposed under the display panel 300 or 400.

The display panel 300 or 400 may include a window member 311 or 411 (e.g., the window member 13 of Fig. 1), a touch panel 312 or 412 (e.g., the touch sensor 31a of Fig. 3), an encapsulation 313 or 413 and a substrate 314 or 414. The above-described pixel layer (e.g., the pixel layer 102 of Fig. 6) and driving circuit layer (e.g., the driving circuit layer 131 of Fig. 6) may be disposed between the encapsulation 313 or 413 and the substrate 314 or 414. A light shielding layer 314a or 414a including a transparent area 314b or 414b may be formed on one surface of the substrate 314 or 414. The light source 341 or 441 (and/or the image sensor 343 or 443) may be disposed corresponding to the transparent area 314b or 414b. As described above, the transparent area 314b or 414b may include an opening(s) (e.g., the opening 113 of Figs. 7a and 7b) that is formed in a net shape.

According to an embodiment of the present disclosure, the electronic device may further include another driving circuit or sensor (hereinafter, 'second driving circuit'). The second driving circuit may include, e.g., a pressure sensor (e.g., the pressure sensor 31c of Fig. 3). According to an embodiment of the present disclosure, a cushion layer 315 or 415 may be formed of an insulating material or dielectric material under the substrate 314 or 414, and a second electrode layer 316 or 416 may be formed opposite the light shielding layer 314a or 414a with the cushion layer 315 or 415 (and/or the substrate 314 or 414) disposed therebetween. The second driving circuit may generate an input signal based on a variation in physical quantity (e.g., voltage, resistance, quantity of electric charge, or capacitance) between the light shielding layer 314a or 414a and the second electrode layer 316 or 416. For example, a pressure sensor (e.g., the pressure sensor 31c of Fig. 3) may be formed of a combination of the second electrode layer 316 or 416 and the light shielding layer 314a or 414a formed of an electrically conductive material. According to a variation in interval between electrodes by the user's touch on the pressure sensor and/or a variation in physical quantity, e.g., capacitance, as per the interval variation, the pressure sensor IC (e.g., the pressure sensor IC 31d of Fig. 3) and/or the processor (e.g., the processor 33 of Fig. 3) may perform a preset function.

According to an embodiment of the present disclosure, the cushion layer 315 or 415 may space the light shielding layer 314a or 414a and the second electrode layer 316 or 416 away from each other at a constant interval. The cushion layer 315 or 415 may be transformed to some degree by the user's touch, and when the touch is removed, may return to its original shape. The cushion layer 315 or 415 may protect the display panel 300 or 400 and/or the substrate 314 or 414. According to an embodiment of the present disclosure, referring to Fig. 10, the cushion layer 415 may include a layer 415a formed of a synthetic resin film and a layer 415b formed of an elastic material.

In certain embodiments, the cushion layer 315 can detect the user's touch, causing a light source 341/441 and image sensor 343/443 to be activated.

According to an embodiment of the present disclosure, the electronic device may further include an image sensor 343 or 443 that is operated along with the light source 341 or 441. The image sensor 343 or 443 may be disposed corresponding to part of the transparent area 314b or 414b and detect an approach or touch of an external body or user's body on the area corresponding to the transparent area 314b or 414b. For example, the image sensor 343 or 443 may include a proximity sensor for detecting whether the user's body approaches. According to an embodiment of the present disclosure, the image sensor 343 or 443 may obtain an image corresponding to the user's body from light that has been emitted from the light source 341 or 441 and reflected back by the user's body. For example, the image sensor 343 or 443 may include a fingerprint recognition sensor or iris sensor, providing user authentication or security functionality. According to an embodiment of the present disclosure, although the image sensor 343 or 443 is, for example, disposed adjacent the light source 341 or 441, the position of the image sensor 343 or 443 may properly be changed depending on, e.g., the direction in which light is emitted, the direction in which the light is reflected by the user's body, and the shape of the transparent area 314b or 414b.

In configuring the pressure sensor (e.g., the pressure sensor 31c of Fig. 3), the two electrode layers may be disposed opposite each other, with an insulating layer and/or dielectric layer disposed therebetween. Such pressure sensor may be attached onto the bottom of the display panel (e.g., the display panel 300 or 400 of Fig. 9 or 10). In this case, the display including the display panel and the pressure sensor may overall thicken. It has been mentioned above that as the display further thickens, more limitations may be imposed to curving the display.

According to an embodiment of the present disclosure, in configuring an additional driving circuit and/or sensor (e.g., the second driving circuit including the pressure sensor), the light shielding layer 314a or 414a embedded in the display panel (e.g., the display panel 300 or 400 of Fig. 9 or 10) may be utilized as an electrode layer for the second driving circuit, suppressing or mitigating the display from thickening. For example, according to an embodiment of the present disclosure, the electronic device (e.g., the display), despite including an additional driving circuit and/or sensor (e.g., a pressure sensor), may readily be transformed into a curved shape.

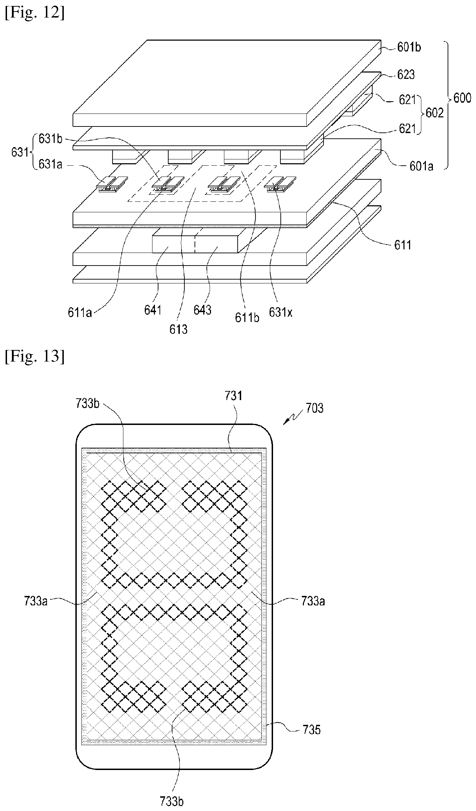

Figs. 11 and 12 are views illustrating an example of a stack of components of an electronic device according to an embodiment of the present disclosure.

Referring to Figs. 11 and 12, according to an embodiment of the present disclosure, an electronic device (e.g., the electronic device 10 of Fig. 1) may include a light source 541 or 641 and a display panel 500 or 600. The light source 541 or 641 may include a light source for emitting light, e.g., IR rays, and may be disposed on the bottom of the display panel 500 or 600. For example, as viewed from above the display panel 500 or 600, the light source 541 or 641 may be disposed in an area overlapping the display panel 500 or 600.

According to an embodiment of the present disclosure, the display panel 500 or 600 may include a sealed pixel layer 502 or 602 and a driving circuit layer 531 or 631 for driving the pixel layer 502 or 602 between a substrate 501a or 601a and an encapsulation 501b or 601b. The pixel layer 502 or 602 may include a plurality of pixels 521 or 621 to display an image and may be formed on an inner surface of the encapsulation 501b or 601b. According to an embodiment of the present disclosure, a first electrode layer 523 or 623 corresponding to the driving circuit layer 531 or 631 may be provided on the inner surface of the encapsulation 501b or 601b. The pixel layer 502 or 602 may be formed on the surface of the first electrode layer 523 or 623. The driving circuit layer 531 or 631 may include driving circuits 531a, 531b, and 531x or 631a, 631b, and 631x each corresponding to a respective one of the plurality of pixels 521 or 621 and facing the pixel layer 502 or 602.

According to an embodiment of the present disclosure, the display panel 500 or 600 may include a light shielding layer 511 or 611. According to an embodiment of the present disclosure, as shown in Fig. 11, the light shielding layer 511, together with the driving circuit layer 531, may be formed on a surface of the substrate 501a, facing and/or contacting the driving circuit layer 531. Alternatively, as shown in Fig. 12, the driving circuit layer 631 may be formed on one surface of the substrate 601a, and the light shielding layer 611 may be formed in contact with the other surface of the substrate 601a.

According to an embodiment of the present disclosure, the light shielding layer 511 or 611 may shield the driving circuit layer 531 or 631 and/or the driving circuits 531a, 531b and 531x or 631a, 631b, and 631x from light emitted from the light source 541 or 641. For example, the light shielding layer 511 or 611 may prevent light emissions from the light source 541 or 641 from distorting or deteriorating the image quality of screen outputted from the display panel 500 or 600.

According to an embodiment of the present disclosure, the light shielding layer 511 or 611 may include a transparent area and/or transmitting pattern (e.g., the opening 513 or 613) formed in part of an area corresponding to the light source 541 or 641 and/or image sensor 543 or 643. For example, the area corresponding to the light source 541 or 641 and/or the image sensor 543 or 643 in the light shielding layer 511 or 611 may block a part of the light emitted from the light source 541 or 641 while transmitting another part of the light. According to an embodiment of the present disclosure, the driving circuits 531a, 531b, and 531x or 631a, 631b, and 631x may be arranged in a light blocking part of the area corresponding to the light source 541 or 641 and/or the image sensor 543 or 643, e.g., the blocking pattern (and/or blocking area) 611a or 611b.

According to an embodiment of the present disclosure, the above-described cushion layer (e.g., the cushion layer 315 of Fig. 9) and the second electrode layer (e.g., the second electrode layer 316 of Fig. 9) may be disposed under the display panel 500 or 600 and/or the light source 541 or 641. For example, the light shielding layer 511 or 611, in combination with the cushion layer and the second electrode layer, may implement a pressure sensor (e.g., the pressure sensor 31c of Fig. 3).

As set forth above, according to an embodiment of the present disclosure, the electronic device may include a light shielding layer formed on one, or its opposite, surface of, e.g., the substrate in the display panel, and may thus be formed overlaid with the light source. For example, according to an embodiment of the present disclosure, the electronic device enables easier arrangement of the light source and/or, proximity sensor, fingerprint recognition sensor, or iris recognition sensor while including a full front display. According to an embodiment of the present disclosure, the light shielding layer may shield the driving circuits of the display panel from light emitted from the light source, preventing a distortion or quality deterioration of screen output.

According to an embodiment of the present disclosure, the light shielding layer, in combination with other electrode layers, implement additional driving circuits and/or sensors. For example, it is possible to easily arrange additional sensors (e.g., the pressure sensor 31c of Fig. 3) while suppressing or mitigating the display from thickening. Thus, the display and/or electronic device including the display may be formed in various shapes, e.g., a curved or rounded shape.

Fig. 13 is a plan view illustrating a window member 703 of an electronic device according to an embodiment of the present disclosure.

Referring to Fig. 13, according to an embodiment of the present disclosure, an electronic device may include a touch panel 731 (e.g., the touch sensor 31a of Fig. 3 and/or antenna device (e.g., a radiating conductor)) integrated with a display. For example, a window member 703 (e.g., the window member 13 of Fig. 1) constituting the display may include conducting line(s) 733a and 733b forming the touch panel 731 and a radiating conductor for transmitting or receiving wireless signals.

According to an embodiment of the present disclosure, the conducting lines 733a and 733b may be arranged generally in a grid pattern, and some (e.g., the conducting lines indicated with reference denotation 733b) of the conducting lines may be combined to form a radiating conductor. According to an embodiment of the present disclosure, the window member 703 may include a looped radiating conductor 735 that is disposed around the touch panel 731. The radiating conductor formed of a combination of some of the conducting lines constituting the touch panel 731 and/or the radiating conductor 735 may be operated as a near-field communication (NFC) antenna.

According to an embodiment of the present disclosure, the light shielding layer may reflect some of wireless signals outputted through the radiating conductor integrated with the window member 703. For example, when the above-described light shielding layer is formed of an electrically conductive material, it may reflect wireless signals, enhancing the radiation capability of the antenna device (e.g., the radiating conductor) integrated with the window member 703. According to an embodiment of the present disclosure, the above-described light shielding layer may be formed over the entire area of the display panel, leading to further enhanced reflection efficiency of radio signals.

As set forth above, according to an embodiment of the present disclosure, an electronic device (e.g., the electronic device 10 of Fig. 1) may comprise a light source (e.g., the light source 19 of Fig. 1 and/or the light source 141 of Fig. 6) for emitting light and a display panel (e.g., the display panel 15 of Fig. 1 and/or the display panel 100 of Fig. 6) for outputting an image, wherein the display panel may include a pixel layer (e.g., the pixel layer 102 of Fig. 6) including a plurality of pixels for displaying the image, a driving circuit layer (e.g., the driving circuit layer 131 of Fig. 6) for driving at least one of the plurality of pixels, and a light shielding layer (e.g., the light shielding layer 111 of Fig. 6) disposed adjacent to the driving circuit layer to block the driving circuit layer from the light, wherein the light shielding layer may be grounded to a ground part (e.g., the ground part GND of Figs. 7a and 7b) formed inside the electronic device.

According to an embodiment of the present disclosure, the plurality of pixels may include a first pixel and a second pixel, wherein the driving circuit layer includes a first driving circuit (e.g., the first driving circuit 131a of Figs. 7a and 7b) for driving the first pixel and a second driving circuit (e.g., the second driving circuit 131b of Figs. 7a and 7b) for driving the second pixel, wherein the light shielding layer may include a first blocking area (e.g., the first blocking area 111a of Figs. 7a and 7b) for shielding the first driving circuit from the light, a second blocking area (e.g., the second blocking area 111b of Figs. 7a and 7b) for shielding the second driving circuit from the light, and a transparent area (e.g., the opening 113 of Figs. 7a and 7b) formed between the first blocking area and the second blocking area, and wherein the display panel may be configured to transmit the light through the transparent area.

According to an embodiment of the present disclosure, the transparent area may include an opening formed in the light shielding layer.

According to an embodiment of the present disclosure, the first blocking area or the second blocking area may be formed of a first material, and the transparent area may be formed of a second material.

According to an embodiment of the present disclosure, the electronic device may further comprise an image sensor (e.g., the image sensor of Fig. 6) for obtaining an image corresponding to a user's body using the light transmitted through the transparent area and the display panel and reflected by the user's body.

According to an embodiment of the present disclosure, the image sensor may include a fingerprint recognition sensor or an iris recognition sensor.

According to an embodiment of the present disclosure, the electronic device may further comprise a circuit board (e.g., the circuit board 17 of Fig. 1) including the ground part, wherein the light shielding layer may include an electrically conductive material and is connected to the ground part.

According to an embodiment of the present disclosure, the driving circuit layer may be formed on a first surface of a substrate (e.g., the substrate 101a of Fig. 6), and the light shielding layer may be formed in contact with a second surface of the substrate which is opposite to the first surface.

According to an embodiment of the present disclosure, the electronic device may further comprise a sensor (e.g., the touch sensor 31a and/or the pressure sensor 31c of Fig. 3), wherein the light shielding layer may ground the sensor.

According to an embodiment of the present disclosure, the sensor may include a pressure sensor.

According to an embodiment of the present disclosure, the sensor may include a cushion layer (e.g., the cushion layer 315 or 415 of Fig. 9 and/or Fig. 10) disposed adjacent the light shielding layer and an electrode layer (e.g., the second electrode layer 316 or 416 of Fig. 9 and/or Fig. 10) disposed facing the light shielding layer with the cushion layer disposed therebetween, and wherein the sensor may be configured to sense a variation in capacitance between the light shielding layer and the electrode layer.

According to an embodiment of the present disclosure, the display panel may further include a near-field communication (NFC) antenna (e.g., a combination of the conducting lines indicated with reference denotation '733b' of Fig. 13) disposed in at least a portion thereof, and wherein the light shielding layer may be configured to reflect at least part of a radio signal outputted through the NFC antenna.

According to an embodiment of the present disclosure, an electronic device may comprise a housing (e.g., the housing 11 of Fig. 1) including a first surface (e.g., the first surface F1 of Fig. 1) and a second surface (e.g., the second surface F2 of Fig. 1) that faces in a different direction from the first surface, a light source (e.g., the light source 19 of Fig. 1 and/or the light source 141 of Fig. 6) disposed in the housing to emit light towards the first surface, a display panel (e.g., the display panel 15 of Fig. 1 and/or the display panel 100 of Fig. 6) disposed between the first surface and the light source and including pixels for displaying an image, a driving circuit (e.g., the driving circuit layer 131 and/or driving circuits 131a, 131b, and 131x of Fig. 6 and/or Figs. 7a and 7b) disposed in the display panel to drive the pixels, and a light shielding layer (e.g., the light shielding layer 111 of Fig. 6) disposed between the driving circuit and the light source, wherein the light shielding layer, as viewed from above the first surface, includes a first area (e.g., the first area A1 of Fig. 8), at least partially, overlapping the light source, a second area (e.g., the second area A2 of Fig. 8) surrounding the first area, a blocking pattern (e.g., the blocking pattern 211a of Fig. 8) formed in the first area to block a part of the light, and a transmitting pattern (e.g., the transmitting pattern 213 of Fig. 8) formed in the first area to transmit another part of the light.

According to an embodiment of the present disclosure, the light shielding layer may include an electrically conductive material.

According to an embodiment of the present disclosure, the light shielding layer may include the electrically conductive material over substantially the entire second area.

According to an embodiment of the present disclosure, the blocking pattern may be disposed to, at least partially, overlap the driving circuit as viewed from above the first surface.

According to an embodiment of the present disclosure, the driving circuit may include semiconductors, and the blocking pattern may be disposed to overlap at least some of the semiconductors as viewed from above the first surface.

According to an embodiment of the present disclosure, the display panel may further include a substrate (e.g., the substrate 101a of Fig. 6), and the driving circuit and the light shielding layer may be formed on a surface of the substrate.

According to an embodiment of the present disclosure, the display panel may further include a substrate, and the driving circuit may be formed on one surface of the substrate, and the light shielding layer is formed on another surface of the substrate.

According to an embodiment of the present disclosure, at least part of the light shielding layer may be grounded to a ground part (e.g., the ground part GND of Figs. 7a and 7b) of a circuit board (e.g., the circuit board 17 of Fig. 1) disposed inside the housing.

While the inventive concept has been shown and described with reference to exemplary embodiments thereof, it will be apparent to those of ordinary skill in the art that various changes in form and detail may be made thereto without departing from the scope of the inventive concept as defined by the following claims.

## Claims

1. An electronic device, comprising:
a light source (141) for emitting light; and
a display panel (100) configured to output an image,
wherein the display panel includes:
a pixel layer (102) including a plurality of pixels (121) configured to display the image,
a driving circuit layer (131) configured to drive at least one of the plurality of pixels, and
a light shielding layer (111) disposed adjacent to the driving circuit layer (131) and configured to block the driving circuit layer (131) from the light,
wherein the light shielding layer (111) is grounded to a ground part (115) formed inside the electronic device (10);
wherein the electronic device comprises a pressure sensor (31c);
**characterized in that** the pressure sensor (31c) includes a cushion layer (315) disposed adjacent the light shielding layer (111) and an electrode layer (316) disposed facing the light shielding layer (111) with the cushion layer (315) disposed therebetween, and wherein the pressure sensor (31c) is configured to sense a variation in capacitance between the light shielding layer (111) and the electrode layer (316).

2. The electronic device of claim 1, wherein the plurality of pixels (121) include a first pixel (121a) and a second pixel (121b), wherein the driving circuit layer (131) includes a first driving circuit (131a) configured to drive the first pixel (121a) and a second driving circuit (131b) configured to drive the second pixel (121b), wherein the light shielding layer (111) includes a first blocking area (111a) configured to shield the first driving circuit (131a) from the light, a second blocking area (111b) configured to shield the second driving circuit (131b) from the light, and a transparent area (113) formed between the first blocking area (111a) and the second blocking area (111b), and wherein the display panel (100) is configured to emit the light through the transparent area 113.

3. The electronic device of claim 2, wherein the transparent area (113) includes an opening (113) formed in the light shielding layer (111).

4. The electronic device of claim 2, further comprising an image sensor (143) configured to obtain an image corresponding to a user's body using the light emitted through the transparent area and the display panel and reflected by the user's body.

5. The electronic device of claim 1, further comprising a circuit board including the ground part (115), wherein the light shielding layer (111) includes an electrically conductive material connected to the ground part (115).

6. The electronic device of claim 1, wherein the driving circuit layer (131) is formed on a first surface of a substrate (101a), and the light shielding layer contacts a second surface of the substrate (101a) which is opposite to the first surface.

7. The electronic device of claim 1, wherein the light shielding layer (111) is configured to ground the pressure sensor (31c).

8. The electronic device of claim 1, wherein the display panel further includes a near-field communication, NFC, antenna (733b) disposed in at least a portion thereof, and wherein the light shielding layer (111) is configured to reflect at least part of a radio signal outputted through the NFC antenna (733b).

9. The electronic device of claim 1, further comprising:
a housing (11) including a first surface (F1) and a second surface (F2) that faces in a different direction from the first surface;
a second light source (19) disposed in the housing to emit light towards the first surface (F1);
wherein the display panel (100) is disposed between the first surface (F1) and the light source, and
the light shielding layer (111) disposed between the driving circuit layer (131) and the second light source (19), wherein the light shielding layer (111), as viewed from above the first surface (F1), includes a first area, at least partially, overlapping the second light source, a second area surrounding the first area, a blocking pattern formed in the first area (111a) to block a part of the light, and a transparent pattern (113) formed in the first area to allow another part of the light.

10. The electronic device of claim 9, wherein the blocking pattern is disposed to, at least partially, overlap the driving circuit (131) as viewed from above the first surface (F1).

## Patentansprüche

1. Elektronische Vorrichtung, welche Folgendes umfasst:
eine Lichtquelle (141) zum Ausstrahlen von Licht; und
ein Anzeigefeld (100), das konfiguriert ist, um ein Bild auszugeben,
wobei das Anzeigefeld Folgendes enthält:
eine Pixelschicht (102), die eine Vielzahl von Pixeln (121) enthält, die konfiguriert sind, um das Bild anzuzeigen,
eine Ansteuerschaltungsschicht (131), die konfiguriert ist, um mindestens eine der Vielzahl von Pixeln anzusteuern, und
eine Lichtabschirmungsschicht (111), die neben der Ansteuerschaltungsschicht (131) angeordnet ist und konfiguriert ist, um die Ansteuerschaltungsschicht (131) von dem Licht zu blockieren,
wobei die Lichtabschirmungsschicht (111) an einem Bodenteil (115) geerdet ist, das in der elektronischen Vorrichtung (10) gebildet ist;
wobei die elektronische Vorrichtung einen Drucksensor (31c) umfasst; **dadurch gekennzeichnet, dass** der Drucksensor (31c) eine Kissenschicht (315) enthält, die neben der Lichtabschirmungsschicht (111) angeordnet ist, und eine Elektrodenschicht (316), die gegenüber der Lichtabschirmungsschicht (111) angeordnet ist, wobei die Kissenschicht (315) dazwischen angeordnet ist, und wobei der Drucksensor (31c) konfiguriert ist, um eine Veränderung der Kapazität zwischen der Lichtabschirmungsschicht (111) und der Elektrodenschicht (316) zu erfassen.

2. Elektronische Vorrichtung nach Anspruch 1, wobei die Vielzahl von Pixeln (121) ein erstes Pixel (121a) und ein zweites Pixel (121b) enthält, wobei die Ansteuerschaltungsschicht (131) eine erste Ansteuerschaltung (131a) enthält, die konfiguriert ist, um das erste Pixel (121a) anzusteuern, und eine zweite Ansteuerschaltung (131b), die konfiguriert ist, um das zweite Pixel (121b) anzusteuern, wobei die Lichtabschirmungsschicht (111) einen ersten Blockierungsbereich (111a) enthält, der konfiguriert ist, um die erste Ansteuerschaltung (131a) von dem Licht abzuschirmen, einen zweiten Blockierungsbereich (111b), der konfiguriert ist, um die zweite Ansteuerschaltung (131b) von dem Licht abzuschirmen, und einen transparenten Bereich (113), der zwischen dem ersten Blockierungsbereich (111a) und dem zweiten Blockierungsbereich (111b) gebildet ist, und wobei das Anzeigefeld (100) konfiguriert ist, um das Licht durch den transparenten Bereich 113 auszustrahlen.

3. Elektronische Vorrichtung nach Anspruch 2, wobei der transparente Bereich (113) eine Öffnung (113) enthält, die in der Lichtabschirmungsschicht (111) gebildet ist.

4. Elektronische Vorrichtung nach Anspruch 2, welche ferner einen Bildsensor (143) umfasst, der konfiguriert ist, um ein Bild zu erhalten, das dem Körper eines Benutzers entspricht, unter Verwenden des Lichts, das durch den transparenten Bereich und das Anzeigefeld ausgestrahlt wird, und von dem Körper des Benutzers reflektiert wird.

5. Elektronische Vorrichtung nach Anspruch 1, welche ferner eine Leiterplatte umfasst, die das Bodenteil (115) enthält, wobei die Lichtabschirmungsschicht (111) ein elektrisch leitendes Material enthält, das mit dem Bodenteil (115) verbunden ist.

6. Elektronische Vorrichtung nach Anspruch 1, wobei die Ansteuerschaltungsschicht (131) auf einer ersten Oberfläche eines Substrats (101a) gebildet ist und die Lichtabschirmungsschicht eine zweite Oberfläche des Substrats (101a) berührt, die der ersten Oberfläche gegenüberliegt.

7. Elektronische Vorrichtung nach Anspruch 1, wobei die Lichtabschirmungsschicht (111) konfiguriert ist, um den Drucksensor (31c) zu erden.

8. Elektronische Vorrichtung nach Anspruch 1, wobei das Anzeigefeld ferner eine Nahfeldkommunikations(NFC)-Antenne (733b) enthält, die in mindestens einem Teil davon angeordnet ist, und wobei die Lichtabschirmungsschicht (111) konfiguriert ist, um mindestens einen Teil eines Funksignals zu reflektieren, das durch die NFC-Antenne (733b) ausgegeben wird.

9. Elektronische Vorrichtung nach Anspruch 1, welche ferner umfasst:
ein Gehäuse (11), das eine erste Oberfläche (F1) und eine zweite Oberfläche (F2) enthält, die in eine andere Richtung als die erste Oberfläche zeigt;
eine zweite Lichtquelle (19), die in dem Gehäuse angeordnet ist, um Licht zu der ersten Oberfläche (F1) auszustrahlen;
wobei das Anzeigefeld (100) zwischen der ersten Oberfläche (F1) und der Lichtquelle angeordnet ist, und
die Lichtabschirmungsschicht (111) zwischen der Ansteuerschaltungsschicht (131) und der zweiten Lichtquelle (19) angeordnet ist, wobei die Lichtabschirmungsschicht (111), von oberhalb der ersten Oberfläche (F1) gesehen, einen ersten Bereich enthält, der die zweite Lichtquelle zumindest teilweise überlappt, einen zweiten Bereich, der den ersten Bereich umgibt, ein Blockierungsmuster, das in dem ersten Bereich (111a) gebildet ist, um einen Teil des Lichts zu blockieren, und ein transparentes Muster (113), das in dem ersten Bereich gebildet ist, um einen anderen Teil des Lichts zuzulassen.

10. Elektronische Vorrichtung nach Anspruch 9, wobei das Blockierungsmuster angeordnet ist, um die Ansteuerschaltung (131), von oberhalb der ersten Oberfläche (F1) gesehen, zumindest teilweise zu überlappen.

## Revendications

1. Dispositif électronique, comprenant :
une source de lumière (141) destinée à émettre de la lumière ; et
un panneau d'affichage (100) configuré pour délivrer en sortie une image,
où le panneau d'affichage comprend :
une couche de pixels (102) incluant une pluralité de pixels (121) configurés pour afficher l'image,
une couche de circuit d'attaque (131) configurée pour attaquer au moins l'un de la pluralité de pixels, et
une couche de protection contre la lumière (111) disposée de manière adjacente à la couche de circuit d'attaque (131) et configurée pour protéger la couche de circuit d'attaque (131) de la lumière,
où la couche de protection contre la lumière (111) est mise à la terre sur une partie de masse (115) formée à l'intérieur du dispositif électronique (10) ;
où le dispositif électronique comprend un capteur de pression (31c) ; **caractérisé en ce que** le capteur de pression (31c) comprend une couche de coussin (315) disposée de manière adjacente à la couche de protection contre la lumière (111) et une couche d'électrode (316) disposée face à la couche de protection contre la lumière (111) avec la couche de coussin (315) disposée entre celles-ci, et où le capteur de pression (31c) est configuré pour détecter une variation de capacité entre la couche de protection contre la lumière (111) et la couche d'électrode (316).

2. Dispositif électronique selon la revendication 1, où la pluralité de pixels (121) comprend un premier pixel (121a) et un deuxième pixel (121b), où la couche de circuit d'attaque (131) comprend un premier circuit d'attaque (131a) configuré pour attaquer le premier pixel (121 a) et un deuxième circuit d'attaque (131a) configuré pour attaquer le deuxième pixel (121b), où la couche de protection contre la lumière (111) comprend un première zone de blocage (111a) configurée pour protéger le premier circuit d'attaque (131a) de la lumière, une deuxième zone de blocage (111b) configurée pour protéger le deuxième circuit d'attaque (131b) de la lumière et une zone transparente (113) formée entre la première zone de blocage (111a) et la deuxième zone de blocage (111b), et où le panneau d'affichage (100) est configuré pour émettre la lumière à travers la zone transparente 113.

3. Dispositif électronique selon la revendication 2, où la zone transparente (113) comprend une ouverture (113) formée dans la couche de protection contre la lumière (111).

4. Dispositif électronique selon la revendication 2, comprenant, en outre, un capteur d'image (143) configuré pour obtenir une image correspondant au corps d'un utilisateur à l'aide de la lumière émise à travers la zone transparente et le panneau d'affichage et réfléchie par le corps de l'utilisateur.

5. Dispositif électronique selon la revendication 1, comprenant, en outre, une carte de circuit imprimé incluant la partie de masse (115), où la couche de protection contre la lumière (111) comprend un matériau électriquement conducteur connecté à la partie de masse (115).

6. Dispositif électronique selon la revendication 1, où la couche de circuit d'attaque (131) est formée sur une première surface d'un substrat (101a) et la couche de protection contre la lumière est en contact avec une deuxième surface du substrat (101a) qui est opposée à la première surface.

7. Dispositif électronique selon la revendication 1, où la couche de protection contre la lumière (111) est configurée pour mettre à la terre le capteur de pression (31c).

8. Dispositif électronique selon la revendication 1, où le panneau d'affichage comprend, en outre, une antenne (733b) de communication en champ proche, NFC, disposée dans au moins une partie de celui-ci, et où la couche de protection contre la lumière (111) est configurée pour réfléchir au moins une partie d'un signal radio émis par l'antenne de NFC (733b).

9. Dispositif électronique selon la revendication 1, comprenant en outre :
un boîtier (11) incluant une première surface (F1) et une deuxième surface (F2) qui fait face à une direction différente de la première surface ;
une deuxième source de lumière (19) disposée dans le boîtier pour émettre de la lumière vers la première surface (F1) ;
où le panneau d'affichage (100) est disposé entre la première surface (F1) et la source de lumière, et
la couche de protection contre la lumière (111) étant disposée entre la couche de circuit d'attaque (131) et la deuxième source de lumière (19), où la couche de protection contre la lumière (111), vue depuis le dessus de la première surface (F1), comprend une première zone, chevauchant au moins partiellement la deuxième source de lumière, une deuxième zone entourant la première zone, un motif de blocage formé dans la première zone (111a) pour bloquer une partie de la lumière et un motif transparent (113) formé dans la première zone pour laisser passer une autre partie de la lumière.

10. Dispositif électronique selon la revendication 9, où le motif de blocage est disposé pour chevaucher, au moins partiellement, le circuit d'attaque (131) lorsqu'il est vu depuis le dessus de la première surface (F1).
